# EUROPEAN PATENT APPLICATION

(11) **EP 4 395 473 A1**
(43) Date of publication of application: **03.07.2024**
(21) Application number: 22861192.7
(22) Date of filing: 17.08.2022
(51) Int. Cl.: H05K 1/03, H01L 23/02, H01L 23/08

(54) **SUBSTRATE FOR MOUNTING ELECTRONIC ELEMENT, ELECTRONIC DEVICE, AND ELECTRONIC MODULE**

(30) Priority: 27.08.2021 JP 2021139371
(71) Applicant: Kyocera Corporation, Kyoto-shi Kyoto 612-8501 (JP)
(72) Inventor: KOHAMA, Kenichi, Kyoto-shi, Kyoto 612-8501 (JP)
(74) Representative: Viering, Jentschura & Partner mbB Patent- und Rechtsanwälte
(86) International application number: PCT/JP2022/030999
(87) International publication number: WO 2023/026904

(57) **Abstract**

In the present disclosure that provides an electronic element mounting substrate capable of reducing the possibility of a change in a size of an element mounting surface even when a position shift occurs at a time of layering a plurality of frame portions, the electronic element mounting substrate includes a base, a first frame portion, and a second frame portion. The first frame portion includes at least one set of a first protrusion portion and a second protrusion portion each protruding further than the second frame portion to a side of an element mounting portion on which an element is mounted. A protrusion width of the first protrusion portion is larger than a protrusion width of the second protrusion portion, and a distance between the first protrusion portion and the element mounting portion is smaller than a distance between the second protrusion portion and the element mounting portion.

## Description

### TECHNICAL FIELD

The present disclosure relates to an electronic element mounting substrate, an electronic device including the electronic element mounting substrate, and an electronic module.

### BACKGROUND OF INVENTION

As an electronic element mounting substrate including a recessed portion inside which an electronic element is accommodated, for example, as disclosed in Patent Document 1 (JP 2005-203485 A), an example is known in which frame portions for forming the recessed portion have a laminate body structure.

### CITATION LIST

### PATENT LITERATURE

Patent Document 1: JP 2005-203485 A

### SUMMARY

In an aspect of the present disclosure, an electronic element mounting substrate includes a base having a rectangular shape in a plan view and comprising an element mounting portion on which an element is mounted; a first frame portion located on an upper surface of the base; and a second frame portion located on an upper surface of the first frame portion. In the electronic element mounting substrate, the first frame portion comprises at least one set of a first protrusion portion and a second protrusion portion each protruding further than the second frame portion to a side of the element mounting portion, a protrusion width of the first protrusion portion is larger than a protrusion width of the second protrusion portion, and a distance between the first protrusion portion and the element mounting portion is smaller than a distance between the second protrusion portion and the element mounting portion.

In an aspect of the present disclosure, an electronic device includes the electronic element mounting substrate and an element.

In an aspect of the present disclosure, an electronic module includes the electronic device and a lid located above the electronic device.

### BRIEF DESCRIPTION OF THE DRAWINGS

FIG. 1 is a cross-sectional view of an electronic module according to a first embodiment of the present disclosure.
FIG. 2 is a cross-sectional view of an electronic device according to the first embodiment of the present disclosure, and is a cross-sectional view taken along the arrow line II-II in FIG. 3.
FIG. 3 is a top view of the electronic device according to the first embodiment of the present disclosure.
FIG. 4 is a cross-sectional view of an electronic element mounting substrate according to the first embodiment of the present disclosure, and is a cross-sectional view taken along the arrow line IV-IV in FIG. 5.
FIG. 5 is a top view of the electronic element mounting substrate according to the first embodiment of the present disclosure.
FIG. 6 is a cross-sectional view of the electronic element mounting substrate according to the first embodiment of the present disclosure, and illustrates an example in which the electronic element mounting substrate includes an insulating film 17 and an insulating film 18.
FIG. 7 is a top view of a first variation of the electronic element mounting substrate.
FIG. 8 is a top view of a second variation of the electronic element mounting substrate.
FIG. 9 is a top view of a third variation of the electronic element mounting substrate.
FIG. 10 is a partial cross-sectional view of a fourth variation of the electronic element mounting substrate.
FIG. 11 is a partial cross-sectional view of a fifth variation of the electronic element mounting substrate.
FIG. 12 is a partial cross-sectional view of a sixth variation of the electronic element mounting substrate.

### DESCRIPTION OF EMBODIMENTS

As in the substrate described in Patent Document 1, a case will be considered in which a plurality of frame portions for forming a recessed portion include opening portions having the same length in a predetermined direction (the frame portions have the same shape). In the case of such a substrate, there has been a concern that the bottom area of the recessed portion, seen from the side of the opening portion when the substrate is viewed in a plan view, is reduced as a result of the position of the opening portion being shifted due to a process error in a layering and pressing process (hereinafter referred to as a layering process).

According to an aspect of the present disclosure, even in a case in which the position shift occurs in the process of layering the plurality of frame portions, the possibility can be reduced of a change in the bottom area of the recessed portion visible from the side of the opening portion when an electronic element mounting substrate is viewed in a plan view.

Several exemplary embodiments of the present disclosure will be described hereinafter with reference to the drawings. In the following description, a configuration in which an element is mounted on an electronic element mounting substrate will be referred to as an electronic device. A configuration including an element and a lid located on the upper surface side of the element will be referred to as an electronic module. With respect to the electronic element mounting substrate, the electronic device, and the electronic module, any direction may be defined as upward or downward, but for the sake of convenience, the orthogonal coordinate system xyz will be used herein, with a positive direction in a z direction defined as upward.

### Embodiment

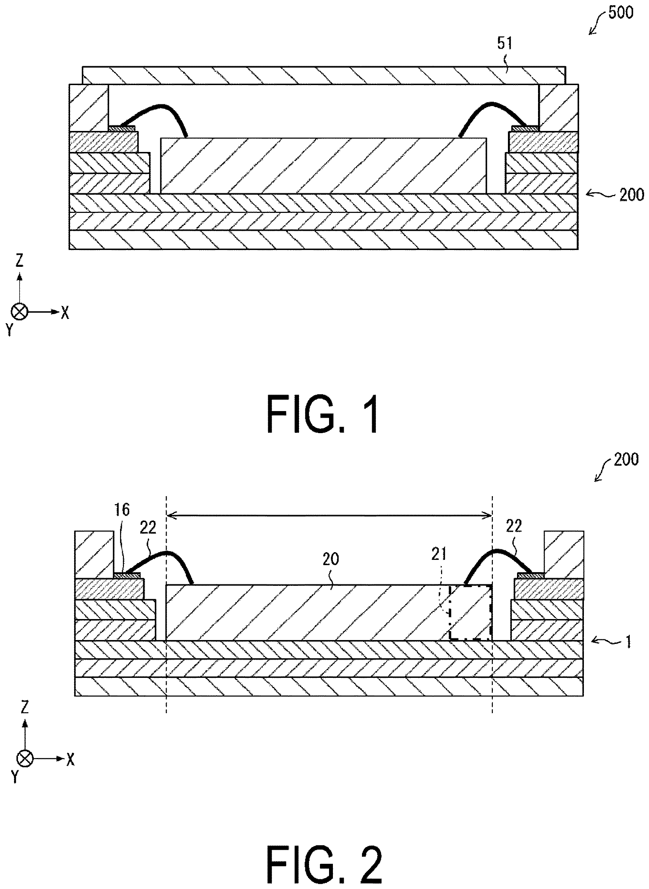

In the following embodiment, an example in which an electronic device 200 includes an element that is an imaging element 20 will be described with reference to FIGs. 1 to 6.

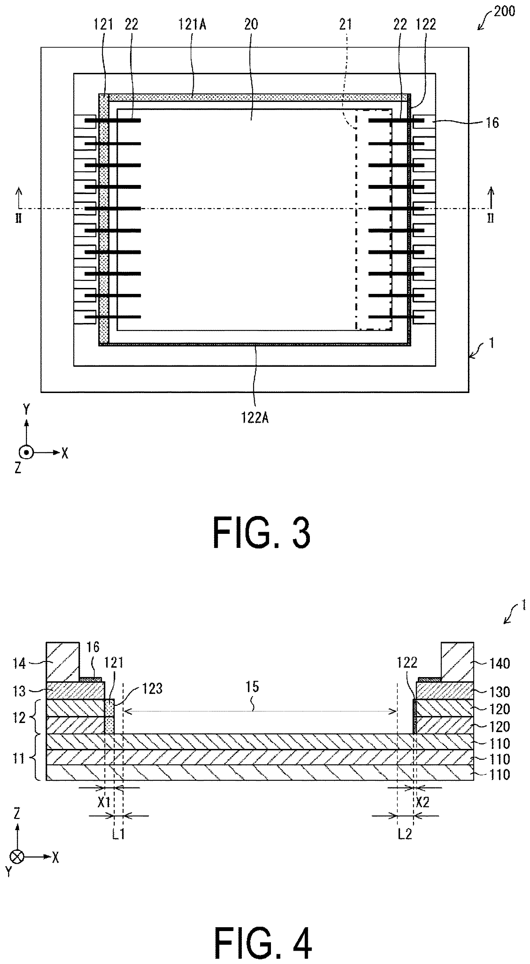

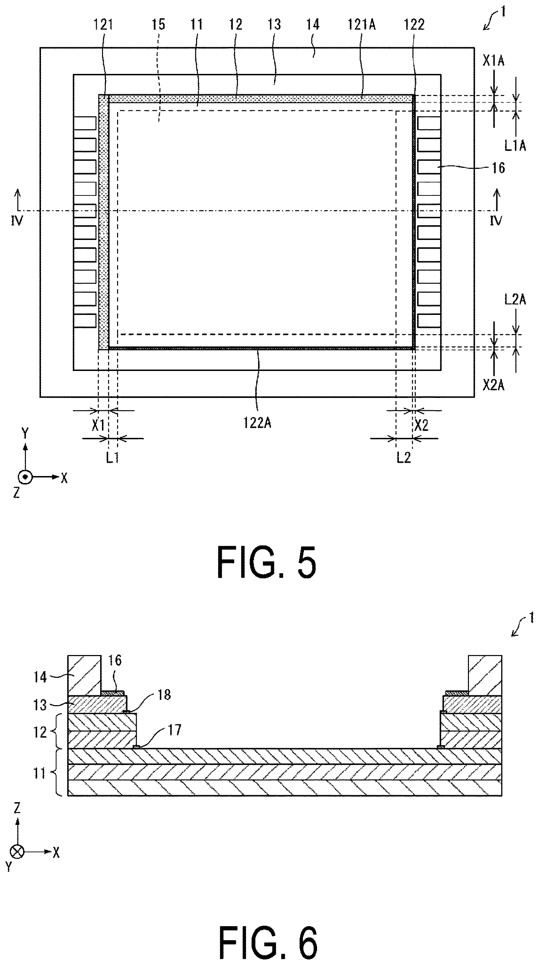

FIG. 1 is a cross-sectional view of an electronic module 500 according to the present embodiment. The electronic module 500 includes the electronic device 200 and a lid 51 located above the electronic device 200. FIG. 2 is a cross-sectional view of the electronic device 200 according to the present embodiment, and is a cross-sectional view taken along the arrow line II-II in FIG. 3. The electronic device 200 includes an electronic element mounting substrate 1 and the imaging element 20. FIG. 3 is a top view of the electronic device 200. FIG. 4 is a cross-sectional view of the electronic element mounting substrate 1 according to the present embodiment, and is a cross-sectional view taken along the arrow line IV-IV in FIG. 5. FIG. 5 is a top view of the electronic element mounting substrate 1. FIG. 6 is a cross-sectional view of the electronic element mounting substrate 1 according to the present embodiment, and illustrates an example in which the electronic element mounting substrate 1 includes an insulating film 17 and an insulating film 18. Hereinafter, constituent elements included in the electronic module 500, the electronic device 200, and the electronic element mounting substrate 1 will be described in detail.

The electronic element mounting substrate 1 is a base for mounting the imaging element 20, and includes a base 11, a first frame portion 12, a second frame portion 13, and a third frame portion 14. With this configuration, the electronic element mounting substrate 1 includes a recessed portion for mounting the imaging element 20. Electrode pads 16 for connection to an element are provided on the upper surface of the second frame portion 13. Terminal electrodes (not illustrated) for connection to an external electrical circuit are provided on the lower surface of the electronic element mounting substrate 1. The terminal electrodes may be provided from the lower surface to the side surface, or on the side surface, instead of being provided on the lower surface of the electronic element mounting substrate 1. The electronic element mounting substrate 1 may include an electrode formed between insulation layers, and a through-hole conductor vertically connecting an internal wiring conductor and internal wiring. These electrodes, internal wiring conductors, or through-hole conductors may be exposed at the surface of the electronic element mounting substrate 1. The electrode pads 16 and the terminal electrodes may be electrically connected by the electrodes, the internal wiring conductors, or the through-hole conductors.

The base 11 has a rectangular shape in a plan view, and includes an element mounting portion 15 on which the imaging element 20 is mounted. The base 11 is constituted by at least one insulation layer 110. The first frame portion 12 is located on the upper surface of the base 11 so as to surround the element mounting portion 15. In other words, when the first frame portion 12 is layered on the upper surface of the base 11, the first frame portion 12 has an opening portion at a position surrounding the element mounting portion 15. The first frame portion 12 is constituted by at least one insulation layer 120. The second frame portion 13 is located on the upper surface of the first frame portion 12, and has the upper surface provided with the electrode pads 16. When the second frame portion 13 is layered on the upper surface of the first frame portion 12, the second frame portion 13 has an opening portion at a position surrounding the element mounting portion 15. The second frame portion 13 is constituted by at least one insulation layer 130. The third frame portion 14 is not necessarily a necessary constituent element, and may be provided on the upper surface of the second frame portion 13 as necessary. The third frame portion 14 may be constituted by an insulation layer 140 as a constituent element of the electronic element mounting substrate 1, or may be integrated with the lid 51 as a part of a constituent element of the lid 51 described later.

In the base 11, the element mounting portion 15 is a region in which the imaging element 20 is mounted. The component mounted on the element mounting portion 15 is not limited to the above-described imaging element 20, and may be at least one of other electronic elements or electronic components. The element mounting portion 15 may be, for example, a region overlapping a component to be mounted on the element mounting portion 15 on the upper surface of the base 11. Alternatively, the element mounting portion 15 may be a region located on the upper surface of the base 11 and surrounded by a virtual line connecting alignment marks used when mounting the component to be mounted on the element mounting portion 15. Alternatively, the element mounting portion 15 may be a region in which a metallization layer for mounting is located, the metallization layer being provided between the component mounted on the element mounting portion 15 and the upper surface of the base 11.

As illustrated in FIG. 6, the base 11 may include the insulating film 17 at a position overlapping the upper surface of the base 11 and the inner edge of the first frame portion 12. With this configuration, a lower portion of the inner edge of the first frame portion 12 is reinforced, and thus, the possibility can be reduced of the first frame portion 12 being deformed due to a pressure at the time of performing layering. Although stress is likely to be applied to the base 11 immediately below the inner edge of the first frame portion and the internal wiring inside the base 11 by the pressure at the time of performing layering, the possibility can be reduced of generation of a crack in the base 11 immediately below the inner edge of the first frame portion or in the internal wiring inside the base 11.

The base 11 is constituted by at least one of the insulation layers 110. The surface of the uppermost insulation layer 110 of the at least one of the insulation layers 110 may be exposed. The exposure of the surface of the insulation layer 110 means that the insulation layer 110 does not include an alumina coating layer or a metallization layer, and an electrically insulating ceramic or the like included in the insulation layer 110 is exposed. As illustrated in FIG. 6, when the insulating film 17 is provided on a part of the surface of the base 11, the other part thereof may be exposed. That is, at least a part of the surface of the uppermost insulation layer 110 may be exposed. In a related art, a method can be given in which an alumina coat or a metallization layer is provided on a surface on which an element is mounted using an adhesive, as a countermeasure against creeping-up of the adhesive. However, the alumina coating layer or the metallization layer may cause adhesion of dust, adhesion of gold plating, irregular reflection of incident light, or the like. Since the surface of the insulation layer 110 located at the uppermost layer of the base 11 is exposed, the possibility of occurrence of a problem such as that described above can be reduced.

In the electronic element mounting substrate 1, the first frame portion 12 is constituted by the plurality of insulation layers 120, and inner side surfaces 123 of the plurality of insulation layers 120 coincide with each other in a plan view. With this configuration, the flatness of the upper surface of the first frame portion 12 can be improved. Thus, the possibility can be reduced of the second frame portion 13 being deformed (drooping) at the time of layering the second frame portion 13.

As illustrated in FIG. 6, the first frame portion 12 may include the insulating film 18 at a position overlapping the upper surface of the first frame portion 12 and the inner edge of the second frame portion 13. With this configuration, a lower portion of the inner edge of the second frame portion 13 is reinforced, and thus, the possibility can be reduced of the second frame portion 13 being deformed due to the pressure at the time of performing layering. The possibility can be reduced of generation of the crack in the first frame portion 12, the base 11, or the internal wiring immediately below the inner edge of the second frame portion 13, to which stress is likely to be applied by the pressure at the time of performing layering.

The first frame portion 12 includes a first protrusion portion 121 and a second protrusion portion 122 each protruding further than the second frame portion 13 to the side of the element mounting portion 15. When the electronic element mounting substrate 1 is made of an electrically insulating ceramic, the insulation layers each in a state of being a ceramic green sheet are layered and pressed. By including the first protrusion portion 121 and the second protrusion portion 122, the possibility can be reduced of the insulation layer 130 drooping when the second frame portion 13 (insulation layer 130) including the electrode pads 16 is layered.

The electronic element mounting substrate 1 includes two sets of combinations of the first protrusion portion 121 and the second protrusion portion 122. For the sake of convenience, the first pair will be referred to as the first protrusion portion 121 and the second protrusion portion 122, and the second pair will be referred to as a first protrusion portion 121A and a second protrusion portion 122A. As illustrated in FIG. 5, in the electronic element mounting substrate 1, the first protrusion portion 121 and the second protrusion portion 122 which are the pair face each other with the element mounting portion 15 interposed therebetween. In the electronic element mounting substrate 1, a protrusion width X1 of the first protrusion portion 121 is larger than a protrusion width X2 of the second protrusion portion 122. A distance L1 between the first protrusion portion 121 and the element mounting portion 15 is smaller than a distance L2 between the second protrusion portion 122 and the element mounting portion 15. Each of the protrusion widths X1 and X2 indicates, for example, the width of the upper surface of the first frame portion 12 protruding from the lower surface of the second frame portion 13. Each of the distances L1 and L2 indicates the distance between the outer edge of the upper surface of the first frame portion 12 on the element mounting portion 15 side and the outer edge of the element mounting portion 15 in a top view. These also apply to when the side surface of the first frame portion 12 and/or the second frame portion 13 on the element mounting portion 15 side is inclined with respect to the bottom surface of the base 11.

A protrusion width X1A of the first protrusion portion 121A is larger than a protrusion width X2A of the second protrusion portion 122A. A distance L1A between the first protrusion portion 121A and the element mounting portion 15 is smaller than a distance L2A between the second protrusion portion 122A and the element mounting portion 15. The protrusion width X1 and the protrusion width X1A may have the same length or may have different lengths. The protrusion width X2 and the protrusion width X2A may also have the same length or may have different lengths. The distance L1 and the distance L1A may have the same length or may have different lengths. The distance L2 and the distance L2A may also have the same length or may have different lengths.

With this configuration, even if a position shift occurs in the layering process of the first frame portion 12 and the second frame portion 13, the possibility can be reduced of a change in the bottom area of the recessed portion visible when the electronic element mounting substrate 1 is viewed from the upper surface thereof. The bottom surface of the recessed portion visible when the electronic element mounting substrate 1 is viewed from the upper surface thereof is a surface region defined by the upper surface of the base 11 and the inner edges of the first frame portion 12 and the second frame portion 13 when the electronic element mounting substrate 1 is viewed from above. The bottom surface of the recessed portion includes the element mounting portion 15, and when the bottom area of the recessed portion is reduced, a problem may occur when an element is mounted. Thus, the fact that the size of the bottom area of the recessed portion does not change is a significant effect in terms of the electronic element mounting substrate.

The imaging element 20 may be disposed on the upper surface of the base 11 with an adhesive interposed therebetween. Examples of the adhesive include a silver epoxy and a thermosetting resin. When the imaging element 20 is mounted using the adhesive, the adhesive is pushed out in some cases. The distance L1 between the first protrusion portion 121 and the element mounting portion 15 is smaller than the distance L2 between the second protrusion portion 122 and the element mounting portion 15. However, since the width X1 of the first protrusion portion 121 is wider than the width X2 of the second protrusion portion 122, the pushed-out adhesive can spread horizontally on the upper surface of the first protrusion portion 121. The width X2 of the second protrusion portion 122 is narrower than the width X1 of the first protrusion portion 121. However, since the distance L2 between the second protrusion portion 122 and the element mounting portion 15 is larger than the distance L1 between the first protrusion portion 121 and the element mounting portion 15, the pushed-out adhesive can spread horizontally on the upper surface of the base 11. Thus, the possibility of the pushed-out adhesive reaching the electrode pads 16 can be reduced. Therefore, in the electronic device 200 and the electronic module 500 each including the electronic element mounting substrate 1, the possibility of deterioration of the electrical characteristics can be reduced.

Since the electronic element mounting substrate 1 has a rectangular shape and the opening portion of the first frame portion 12 also has a rectangular shape, it can be said that the protrusion width X1 is the distance between the short side of the opening portion of the first frame portion 12 and the element mounting portion. It can be also said that the protrusion width X1A is the distance between the long side of the opening portion of the first frame portion 12 and the element mounting portion. In the electronic element mounting substrate 1, the distance between the short side of the opening portion of the first frame portion 12 and the element mounting portion 15 may be larger than the distance between the long side of the opening portion and the element mounting portion 15. With this configuration, by increasing the distance between the inner edge of the frame portion and the element mounting portion on the side of the short side on which the adhesive is more likely to creep up, the possibility can be further reduced of the adhesive reaching the electrode pads provided on an upper portion of the second frame portion.

In the electronic element mounting substrate 1, when a direction (z direction) perpendicular to the upper surface of the base 11 is a thickness direction, the thickness of the first frame portion 12 may be larger than the thickness of the second frame portion 13. Alternatively, the number of the insulation layers 110 of the first frame portion 12 may be greater than the number of the insulation layers 130 of the second frame portion 13. With this configuration, the strength of the electronic element mounting substrate 1 is improved. The possibility is further reduced of the adhesive reaching the electrode pads 16 provided on the upper portion of the second frame portion.

The imaging element 20 may be, for example, an imaging element of a complementary metal oxide semiconductor (CCD) type, a complementary metal oxide semiconductor (CMOS) type, or the like. Although an example in which the electronic device 200 includes the imaging element 20 is described in the present embodiment, the element according to the present disclosure is not limited to the imaging element. The element according to the present disclosure may be a light-emitting element such as a light-emitting diode (LED) or a laser diode (LD), an element having a sensor function of sensing pressure, air pressure, acceleration, gyro, or the like, an integrated circuit, or the like in addition to the imaging element 20. The imaging element 20 and the electronic element mounting substrate 1 may be electrically connected to each other by, for example, connecting members 22 such as wire bonding members.

Given the characteristics of the imaging element 20, it may include a heat generating portion 21. The heat generating portion 21 is a portion that is more likely to generate heat than other portions, and is, for example, a calculation unit. As illustrated in FIGs. 2 and 3, normally, the heat generating portion 21 can be present at a position displaced to one side from the center of the element. In the present embodiment, the heat generating portion 21 is located closer to the second protrusion portion 122 than to the first protrusion portion 121. With this configuration, in the electronic device 200 and the electronic module 500, the distance between the heat generating portion and the internal wiring present inside the first frame portion 12 and the second frame portion 13 can be increased. Thus, a resistance change due to heat can be reduced, and the electrical characteristics of the electronic device 200 and the electronic module 500 can be improved.

When the element to be mounted on electronic device 200 is the imaging element such as a CCD or a CMOS, or the light-emitting element such as an LED or an LD, a member having high transparency such as a glass material is used for the lid 51. The lid 51 may include a lens holder and a lens made of a resin, liquid, glass, crystal, or the like. When the element to be mounted on the electronic device 200 is the integrated circuit or the like, a metal material, a ceramic material, or an organic material may be used as the material for the lid 51. The lid 51 may be bonded to the electronic element mounting substrate 1 using a lid bonding material. As the lid bonding material, a thermosetting resin, low-melting point glass, or a brazing material containing a metal component may be used, for example.

In the electronic element mounting substrate 1, the material of the insulation layers 110, 120, 130, and 140 included in the electronic element mounting substrate 1 includes, for example, an electrically insulating ceramic or a resin. As the electrically insulating ceramic, for example, a ceramic such as an aluminum oxide sintered body (alumina ceramic), an aluminum nitride sintered body, a silicon nitride sintered body, a mullite sintered body, or a glass ceramic sintered body can be used. Examples of the resin include an epoxy resin, a polyimide resin, an acrylic resin, a phenol resin, and a fluorine-based resin. Examples of the fluorine-based resin include a polyester resin and a tetrafluoroethylene resin.

When the electronic element mounting substrate 1 is, for example, an aluminum oxide sintered body, a slurry is produced by adding a suitable organic binder, solvent, and the like to a raw material powder of aluminum oxide (Al₂O₃), silicon oxide (SiO₂), magnesium oxide (MgO), calcium oxide (CaO), or the like, and then mixing them. A ceramic green sheet is produced by forming this slurry into a sheet by employing a well-known doctor blade method, calender roll method, or the like. This ceramic green sheet is subjected to an appropriate punching process, and multiple ceramic green sheets are layered to form a green body, which is then fired at a high temperature (approximately 1600°C) to produce the electronic element mounting substrate 1.

The electrode pads 16 and the terminal electrodes mainly contain, for example, metals such as tungsten, molybdenum, manganese, copper, silver, palladium, gold, platinum, nickel, or cobalt, or alloys containing any of these metals as conductor materials. The electrode pads 16 and the terminal electrodes are formed on the surfaces of the electronic element mounting substrate 1 as metal layers such as metallization layers or plating layers of a conductor material. The internal wiring conductor is formed inside the electronic element mounting substrate 1 by metallization of a conductor material.

When the electrode pads 16, the internal wiring conductors, and the terminal electrodes are, for example, metallization layers of tungsten, they can be formed by printing a metal paste prepared by mixing tungsten powder with an organic solvent and an organic binder at predetermined positions on the ceramic green sheets to be the electronic element mounting substrate 1 by a screen printing method or the like and firing the paste. A plating layer of nickel, gold, or the like may be further deposited on exposed surfaces of the metallization layers, which serve as the internal wiring conductors and the terminal electrodes, by an electrolytic plating method, an electroless plating method, or the like.

### First Variation of Electronic Element Mounting Substrate 1

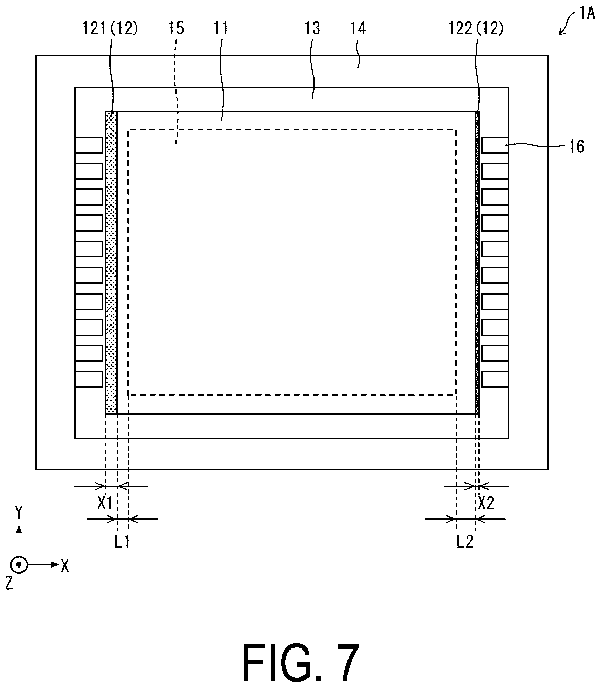

Hereinafter, a first variation of the electronic element mounting substrate 1 will be described with reference to FIG. 7. For the sake of convenience of description, members having the same functions as those of the members described in the above-described embodiment are denoted by the same reference signs, and description thereof is not repeated. The same applies to other variations. FIG. 7 is a top view of an electronic element mounting substrate 1A, which is the first variation of the electronic element mounting substrate 1.

The electronic element mounting substrate 1A illustrated in FIG. 7 is different from the above-described electronic element mounting substrate 1 in that only one combination of the first protrusion portion 121 and the second protrusion portion 122 is provided. Other configurations are the same as those of the electronic element mounting substrate 1. In this case, in a top view, the first protrusion portion 121 and the second protrusion portion 122 are located between the element mounting portion 15 and the electrode pads 16.

The electronic element mounting substrate 1A having this configuration also achieves the same or similar effects as those of the above-described electronic element mounting substrate 1. Since the electronic element mounting substrate 1A has one set of sides provided with no protrusion portion, the electronic element mounting substrate 1A can be downsized.

### Second Variation of Electronic Element Mounting Substrate 1

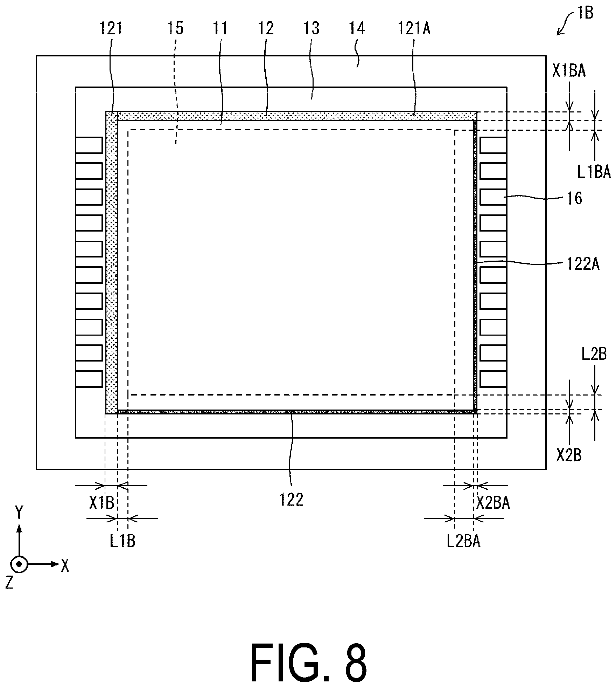

A second variation of the electronic element mounting substrate 1 will be described with reference to FIG. 8. FIG. 8 is a top view of an electronic element mounting substrate 1B, which is the second variation of the electronic element mounting substrate 1.

The electronic element mounting substrate 1B illustrated in FIG. 8 includes two sets of combinations of the first protrusion portion 121 and the second protrusion portion 122. The electronic element mounting substrate 1B is different from the above-described electronic element mounting substrate 1 in that the first protrusion portion 121 and the second protrusion portion 122 which are a pair are adjacent to each other. In other words, in the electronic element mounting substrate 1B, the first protrusion portion 121 and the second protrusion portion 122 which are the pair are arranged in an L shape in a top view. Other configurations are the same as those of the electronic element mounting substrate 1.

In the electronic element mounting substrate 1B, a protrusion width X1B of the first protrusion portion 121 is larger than a protrusion width X2B of the second protrusion portion 122. A distance L1B between the first protrusion portion 121 and the element mounting portion 15 is smaller than a distance L2B between the second protrusion portion 122 and the element mounting portion 15.

The electronic element mounting substrate 1B having this configuration also achieves the same or similar effects as those of the above-described electronic element mounting substrate 1.

### Third Variation of Electronic Element Mounting Substrate 1

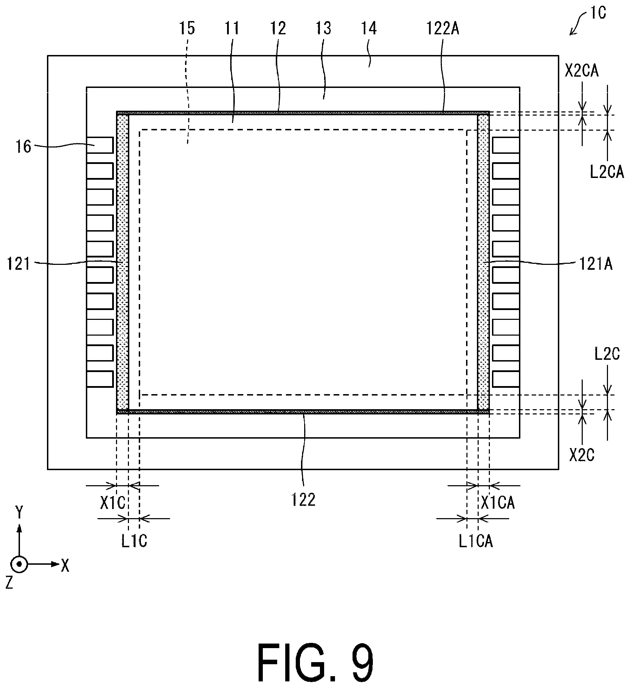

A third variation of the electronic element mounting substrate 1 will be described with reference to FIG. 9. FIG. 9 is a top view of an electronic element mounting substrate 1C, which is the third variation of the electronic element mounting substrate 1.

The electronic element mounting substrate 1C illustrated in FIG. 9 includes two sets of combinations of the first protrusion portion 121 and the second protrusion portion 122. The electronic element mounting substrate 1C is different from the electronic element mounting substrate 1 in that the one first protrusion portion 121 and the other first protrusion portion 121A face each other with the element mounting portion 15 interposed therebetween. In the electronic element mounting substrate 1C, the first protrusion portion 121 and the second protrusion portion 122 which are a pair are adjacent to each other. In other words, in the electronic element mounting substrate 1B, the first protrusion portion 121 and the second protrusion portion 122 which are the pair are arranged in an L shape in a top view.

In the electronic element mounting substrate 1C, in each of the pairs, a protrusion width X1C of the first protrusion portion 121 is larger than a protrusion width X2C of the second protrusion portion 122. A distance L1C between the first protrusion portion 121 and the element mounting portion 15 is smaller than a distance L2C between the second protrusion portion 122 and the element mounting portion 15.

In the electronic element mounting substrate 1C, both of the two second protrusion portions 121 and 121A are located between the element mounting portion 15 and the electrode pads 16 in a top view. Since widths X1 and X1A of the first protrusion portions 121 and 121A are wider than widths X2 and A2A of the second protrusion portions 122 and 122A, the pushed-out adhesive can spread horizontally on the upper surfaces of the first protrusion portions 121 and 121A. Thus, the possibility of the pushed-out adhesive reaching the electrode pads 16 can be further reduced.

In another aspect of the electronic element mounting substrate 1C, the one second protrusion portion 122 and the other second protrusion portion 122A may face each other with the element mounting portion 15 interposed therebetween.

In this case, since a distance L2 between the second protrusion portion 122 and the element mounting portion 15 is larger than a distance L1 between the first protrusion portion 121 and the element mounting portion 15, the pushed-out adhesive can spread horizontally on the upper surface of the base 11. Thus, the possibility of the pushed-out adhesive reaching the electrode pads 16 can be further reduced.

### Fourth Variation of Electronic Element Mounting Substrate 1

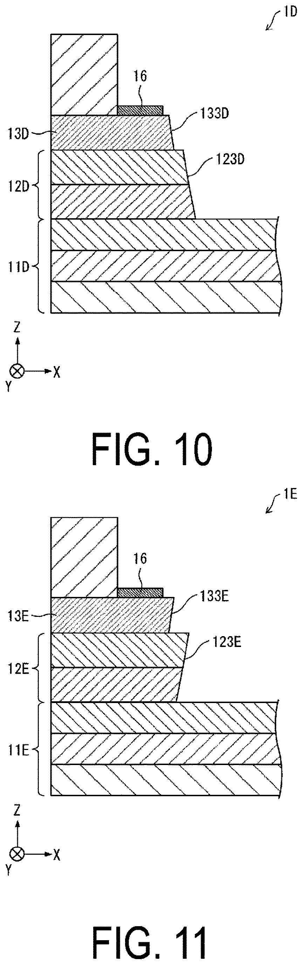

A fourth variation of the electronic element mounting substrate 1 will be described with reference to FIG. 10. FIG. 10 is a partial cross-sectional view of an electronic element mounting substrate 1D, which is the fourth variation of the electronic element mounting substrate 1.

As illustrated in FIG. 10, the electronic element mounting substrate 1D includes a base 11D, a first frame portion 12D, and a second frame portion 13D. An inner side surface 123D of the first frame portion 12D and an inner side surface 133D of the second frame portion 13D are inclined outward with respect to the bottom surface of the base 11D.

With this configuration, at the inner side surface 123D of the first frame portion 12D and the inner side surface 133D of the second frame portion 13D, the distance from the bottom surface to the upper surface of each of the frame portions can be increased. Thus, the possibility can be further reduced of the adhesive used when mounting the element reaching the electrode pads 16 provided on an upper portion of the second frame portion 13D.

### Fifth Variation of Electronic Element Mounting Substrate 1

A fifth variation of the electronic element mounting substrate 1 will be described with reference to FIG. 11. FIG. 11 is a partial cross-sectional view of an electronic element mounting substrate 1E, which is the fifth variation of the electronic element mounting substrate 1.

As illustrated in FIG. 11, the electronic element mounting substrate 1E includes a base 11E, a first frame portion 12E, and a second frame portion 13E. An inner side surface 123E of the first frame portion 12E and an inner side surface 133E of the second frame portion 13E are inclined inward with respect to the bottom surface of the base 11D.

With this configuration, an acute angle can be provided between the inner side surface 123E and the bottom surface of the first frame portion 12E. An acute angle can be provided between the inner side surface 133E of the second frame portion 13E and the upper surface of the first frame portion 12E. Thus, the adhesive used when mounting the element is trapped by acute angle portions, and further, since each of the inner side surfaces is inclined inward, creeping-up of the adhesive can be suppressed. Thus, the possibility can be further reduced of the adhesive reaching the electrode pads 16 provided on an upper portion of the second frame portion 13E.

### Sixth Variation of Electronic Element Mounting Substrate 1

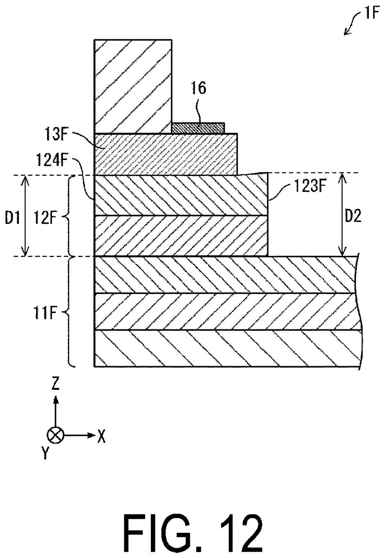

A sixth variation of the electronic element mounting substrate 1 will be described with reference to FIG. 12. FIG. 12 is a partial cross-sectional view of an electronic element mounting substrate 1F, which is the sixth variation of the electronic element mounting substrate 1.

As illustrated in FIG. 12, the electronic element mounting substrate 1F includes a base 11F, a first frame portion 12F, and a second frame portion 13F. When a direction (z direction) perpendicular to the upper surface of the base 11F is defined as a thickness direction, the thickness of an inner side surface 123F of the first frame portion 12F is thicker than an outer side surface 124F of the first frame portion 12F.

With this configuration, the possibility can be further reduced of the adhesive used when mounting the element reaching the electrode pads 16 provided on an upper portion of the second frame portion 13F.

### Supplementary Note

In the present disclosure, the invention has been described above based on the various drawings and examples. However, the invention according to the present disclosure is not limited to each embodiment described above. That is, the invention according to the present disclosure can be modified in various ways within the scope illustrated in the present disclosure, and embodiments obtained by appropriately combining the technical means disclosed in different embodiments are also included in the technical scope of the invention according to the present disclosure. In other words, a person skilled in the art can easily make various variations or modifications based on the present disclosure. Note that these variations or modifications are included within the scope of the present disclosure.

### REFERENCE SIGNS

1, 1A, 1B, 1C, 1D, 1E, 1F Electronic element mounting substrate
11, 11D, 11E, 11F Base
12, 12D, 12E, 12F First frame portion
121, 121A First protrusion portion
13, 13D, 13E, 13F Second frame portion
122, 122A Second protrusion portion
14 Third frame portion
15 Element mounting portion
16 Electrode pad
17, 18 Insulating film
20 Imaging element (element)
21 Heat generating portion
22 Connecting member
51 Lid
110, 120, 130, 140 Insulation layer
200 Electronic device
500 Electronic module

## Claims

1. An electronic element mounting substrate comprising:
a base having a rectangular shape in a plan view and comprising an element mounting portion on which an element is mounted;
a first frame portion located on an upper surface of the base; and
a second frame portion located on an upper surface of the first frame portion, wherein
the first frame portion comprises at least one set of a first protrusion portion and a second protrusion portion each protruding further than the second frame portion to a side of the element mounting portion,
a protrusion width of the first protrusion portion is larger than a protrusion width of the second protrusion portion, and
a distance between the first protrusion portion and the element mounting portion is smaller than a distance between the second protrusion portion and the element mounting portion.

2. The electronic element mounting substrate according to claim 1, wherein
the base is constituted by at least one insulation layer, and
a surface of the insulation layer located at an uppermost layer is exposed.

3. The electronic element mounting substrate according to claim 1 or 2, wherein
a direction perpendicular to the upper surface of the base is a thickness direction, and
a thickness of the first frame portion is larger than a thickness of the second frame portion.

4. The electronic element mounting substrate according to any one of claims 1 to 3, wherein
the first frame portion is constituted by a plurality of insulation layers, and inner side surfaces of the plurality of insulation layers coincide with each other in a plan view.

5. The electronic element mounting substrate according to any one of claims 1 to 4, wherein
the base comprises an insulating film at a position at which the upper surface of the base and an inner edge of the first frame portion overlap with each other.

6. The electronic element mounting substrate according to any one of claims 1 to 5, wherein
the first frame portion comprises an insulating film at a position at which the upper surface of the first frame portion and an inner edge of the second frame portion overlap with each other.

7. The electronic element mounting substrate according to any one of claims 1 to 3, wherein
at least one of an inner side surface of the first frame portion or an inner side surface of the second frame portion is inclined with respect to a bottom surface of the base.

8. The electronic element mounting substrate according to any one of claims 1 to 7, wherein
a direction perpendicular to the upper surface of the base is a thickness direction, and
a thickness of an inner side surface of the first frame portion is larger than a thickness of an outer side surface of the first frame portion.

9. The electronic element mounting substrate according to any one of claims 1 to 8, wherein
a shape of an opening portion of the first frame portion is a rectangular shape, and a distance between a short side of the opening portion and the element mounting portion is larger than a distance between a long side of the opening portion and the element mounting portion.

10. An electronic device comprising:
the electronic element mounting substrate according to any one of claims 1 to 9; and
an element.

11. The electronic device according to claim 10, wherein
the element comprises a heat generating portion, and
the heat generating portion is located at a position closer to the second protrusion portion than to the first protrusion portion.

12. An electronic module comprising:
the electronic device according to claim 10 or 11; and
a lid located above the electronic device.
